# EUROPEAN PATENT APPLICATION

(11) **EP 2 669 401 A1**
(43) Date of publication of application: **04.12.2013**
(21) Application number: 12169796.5
(22) Date of filing: 29.05.2012
(51) Int. Cl.: C23C 14/02, C23C 14/06, C23C 14/32, C23C 14/35, C23C 30/00, C23C 14/34

(54) **Method for depositing a coating and a coated cutting tool**

(71) Applicant: Seco Tools AB, 737 82 Fagersta (SE)
(72) Inventor: Andersson, Jon, 723 51 Västerås (SE); Sjölén, Jacob, 737 43 Fagersta (SE); Johansson, Mats, 589 37 Linköping (SE)
(74) Representative: Hammarsjö, Joakim

(57) **Abstract**

The present invention relates to a method for depositing a hard and wear resistant layer onto a tool body (1) of a hard alloy of, for example, cemented carbide, cermet, ceramics, cubic boron nitride based material or high speed steel. The method comprises depositing the layer by highly ionised physical vapour deposition using elemental, composite and/or alloyed source material comprising the elements Me, where Me is one or more of Ti, V, Cr, Y, Zr, Nb, Mo, Hf, Ta, W, B, Al, Si, and C, using a process gas comprising one or more of the elements C, N, O, and S, preferably one or more of C, N, and O, and applying a first substrate bias potential, U_{b1}, where -900 V < U_{b1} < -250 V, during at least one fraction, Dₕᵢ, i=1,2,3,..., of the total layer deposition time, Dₜₒₜ, where Dₕᵢ > 0.05Dₜₒₜ. The invention also relates to a cutting tool for metal machining by chip removal, wherein said tool comprises a tool body (1) of a hard alloy of, for example, cemented carbide, cermet, ceramics, cubic boron nitride based material or high speed steel, onto at least part of which a hard and wear resistant coating is deposited, wherein said coating comprises at least one layer (2) deposited according to the method.

## Description

### TECHNICAL FIELD OF THE INVENTION

The present invention relates to a cutting tool for chip forming metal machining onto at least part of which a layer is deposited by means of highly ionised physical vapour deposition, preferably cathodic arc evaporation.

### BACKGROUND OF THE INVENTION

The increased productivity in modem chip forming metal machining requires tools with high reliability and excellent wear properties. It has been known since the end of the 1960s that tool life can be significantly improved by applying a suitable coating to the surface of the tool. Chemical vapour deposition (CVD) was the first deposition technique used for cutting tools and this method is still commonly used for deposition of TiN, Ti(C,N), and Al₂O3. Physical Vapour Deposition (PVD) was introduced in the 1980s and has since then been developed from deposition of stable metallic compounds like TiN or Ti(C,N) to include deposition of multicomponent, metastable compounds like (Ti,Al)N, (Ti,Si)N, (Al,Cr)N, or (Al,Cr)₂O₃ by such methods as sputtering or cathodic arc evaporation. As is well known in the art the substrate bias potential is an important process parameter which has to be adapted to the specific coating composition and application. In addition, US2007218242 and EP2298954 describe variations in substrate bias potentials in order to further improve performance. Although the tool performance has been greatly improved by the mentioned findings, the inventors have noticed the need of a means for further improving the wear resistance of the cutting tools.

### OBJECT OF THE INVENTION

It is thus an object of the present invention to provide a coated cutting tool giving increased wear resistance.

### SUMMARY OF THE INVENTION

To our surprise, we have found that the above object is attained by depositing a layer onto a tool body by means of a highly ionised physical vapour deposition technique, preferably cathodic arc evaporation, using a very high (negative) substrate bias potential during at least 5% of the total layer deposition time.

According to a first aspect, the present invention provides a method for depositing a hard and wear resistant coating onto a tool body of a hard alloy of, e.g., cemented carbide, cermet, ceramics, cubic boron nitride based material or high speed steel, wherein said coating comprises a layer comprising at least one first sublayer, said method comprises depositing the layer by highly ionised physical vapour deposition using elemental, composite and/or alloyed source material comprising the elements Me, where Me is one or more of Ti, V, Cr, Y, Zr, Nb, Mo, Hf, Ta, W, B, Al, Si, and C, preferably one or more of Ti, V, Cr, Y, Zr, Nb, Al, and Si, most preferably one or more of Ti, Cr, Al, and Si, and in addition the source material may contain traces of impurities, using a process gas comprising one or more of the elements C, N, O, and S, preferably one or more of C, N, and O, most preferably one or more of N₂ and O₂, and in addition the process gas may contain a noble gas, hydrogen, and traces of impurities, and applying a first substrate bias potential, U_{b1}, where -900 V < U_{b1} < -250 V, during at least one fraction, Dₕᵢ, i=1,2,3,..., of the total layer deposition time, Dₜₒₜ, where Dₕᵢ > 0.05Dₜₒₜ, preferably Dₕᵢ > 0.1Dₜₒₜ.

Thereby a coated cutting tool having increased wear resistance is achieved. The first substrate bias potential, U_{b1}, can vary within each fraction Dₕᵢ, but is always between - 250 and -900 V during each fraction Dₕᵢ. The layer thus produced contains at least one first sublayer, each first sublayer being deposited during a fraction Dₕᵢ.

According to one embodiment of the invention Dₕᵢ > 0.05Dₜₒₜ for all fractions Dₕᵢ of the total deposition time for depositing the layer, where i=1,2,3,..., preferably Dₕᵢ > 0.1Dₜₒₜ for all fractions Dₕᵢ.

According to an embodiment of the invention the method comprises applying a second substrate bias potential, U_{b2}, where -150 V < U_{b2} < 0 V, during at least one fraction, Dₗᵢ, i=1,2,3,..., of the total deposition time, Dₜₒₜ, said fractions Dₗᵢ being located before, after, and/or between fractions Dₕᵢ. The second bias potential, U_{b2}, can vary within each fraction Dₗᵢ, but is always between 0 and -150 V during each fraction Dₗᵢ. The layer thus produced contains at least one second sublayer, in addition to at least one first sublayer, each second sublayer being deposited during a fraction Dₗᵢ.

According to one embodiment of the invention the substrate bias potential ramping time, between a fraction Dₕᵢ and a fraction Dₗᵢ or between a fraction Dₗᵢ and a fraction Dₕᵢ, is less than 0.02Dₜₒₜ, preferably less than 0.01Dₜₒₜ. Such substrate bias potential ramping may take place several times during one layer deposition and according to this embodiment of the invention each ramping time is less than 0.02Dₜₒₜ. The short ramping time is beneficial under many process conditions in order to avoid excessive residual stress produced by deposition using a substrate bias potential in the intermediate range between -150 and -250 V.

According to one embodiment of the invention the first substrate bias potential, U_{b1}, is between -300 and -700 V.

According to one embodiment of the invention the method comprises
- using cathodic arc evaporation with one or more cathodes,
- applying a process pressure, p, where 0.3 Pa < p < 8 Pa, preferably 0.5 < p < 6 Pa,
- applying a process temperature, T, where 200°C < T < 800°C, preferably 300°C < T < 600°C, and
- applying an evaporation current between 50 and 300 A for each cathode, preferably between 50 and 200 A for each cathode.

According to one embodiment of the invention the method comprises
- using highly ionised magnetron sputtering,
- applying a process pressure, p, where 0.1 Pa < p < 5 Pa, preferably 0.1 < p < 2.5 Pa,
- applying a process temperature, T, where 200°C < T < 800°C, preferably 300°C < T < 600°C, and
- applying an average power density to the sputter target between 0.5 and 15 W/cm², preferably between 1 and 5 W/cm². The high ionisation may for example be achieved by an ionisation apparatus or by using a power supply producing a pulsed signal with very high peak power.

According to one embodiment of the invention the layer deposition includes at least two fractions Dₕᵢ.

According to one embodiment of the invention Dₕᵢ > 0.3Dₜₒₜ.

According to one embodiment of the invention the layer deposition consists of at least one sequence Dₗᵢ + Dₕᵢ, i=1,2,3,..., each fraction Dₕᵢ being located at the end of each sequence Dₗᵢ + Dₕᵢ. Thereby a layered structure of alternating second and first sublayers is achieved.

According to one embodiment of the invention the layer deposition comprises a single fraction Dₕ₁, and a single fraction Dₗ₁, said fraction Dₕ₁ being located at the end of the layer deposition time.

According to one embodiment of the invention the method comprises using a source material having a composition according to the chemical formula Ti_{1-X1-Y1}Al_{X1}Me_{Y1}, where 0.2 < X1 < 0.7, preferably 0.4 < X1 < 0.7, 0 ≤ Y1 < 0.3, preferably 0 ≤ Y1 < 0.15, most preferably Y1 = 0, and a process gas containing one or more of the elements N, C, and O, preferably said process gas is N₂.

According to one embodiment of the invention the method comprises using a source material having a composition according to the chemical formula Ti_{1-X1-Y1}Al_{X1}-Me_{Y1}, where 0.2 < X1 < 0.7, preferably 0.4 < X1 < 0.7, 0 ≤ Y1 < 0.3, preferably 0 ≤ Y1 < 0.15, most preferably Y1 = 0, using a process gas containing one or more of the elements N, C, and O, preferably said process gas is N₂, and the layer deposition contains only one fraction, Dₕ₁, said fraction Dₕ₁ being located at the end of the layer deposition time.

According to one embodiment of the invention the method comprises using a source material having a composition according to the chemical formula Ti_{1-X2-Y2}Al_{X2}-Me_{Y2} where 0.02 < X2 < 0.30, 0 ≤ Y2 < 0.3, preferably 0 ≤ Y2 < 0.15, most preferably Y2 = 0, and a process gas containing one or more of the elements N, C, and O, preferably said process gas is N₂.

According to one embodiment of the invention the method comprises using a source material having a composition according to the chemical formula Cr_{1-X3-Y3}Al_{X3}Me_{Y3}, where 0 ≤ X3 < 0.75, preferably 0.3 < X3 < 0.75, 0 ≤ Y3 < 0.3, preferably 0 ≤ Y3 < 0.15, most preferably Y3 = 0, and a process gas containing one or more of the elements N, C, and O, preferably said process gas is O₂.

According to one embodiment of the invention the method comprises using a source material having a composition according to the chemical formula Cr_{1-X3-Y3}Al_{X3}Me_{Y3}, where 0.3 < X3 < 0.75, 0 ≤ Y3 < 0.3, preferably 0 ≤ Y3 < 0.15, most preferably Y3 = 0, and a process gas consisting of N₂.

According to one embodiment of the invention, the method comprises using a source material consisting of Ti and a process gas containing one or more of the elements N, C, and O, preferably said process gas is N₂.

According to one embodiment of the invention, the method comprises using at least two different, simultaneously active, source materials having different chemical compositions.

According to one embodiment of the invention, the method comprises using two different, simultaneously active, source materials having compositions according to the chemical formulas Ti_{1-X1-Y1}Al_{X1}-Me_{Y1}, where 0.2 < X1 < 0.7, preferably 0.4 < X1 < 0.7, 0 ≤ Y1 < 0.3, preferably 0 ≤ Y1 < 0.15, most preferably Y1 = 0, and Ti_{1-X2-Y2}Al_{X2}-Me_{Y2} where 0.02 < X2 < 0.30, 0 ≤ Y2 < 0.3, preferably 0 ≤ Y2 < 0.15, most preferably Y2 = 0, and using a process gas containing one or more of the elements N, C, and O, preferably said process gas is N₂.

According to a second aspect of the present invention, a cutting tool for metal machining by chip removal is provided, wherein said tool comprises a tool body of a hard alloy of, for example, cemented carbide, cermet, ceramics, cubic boron nitride based material or high speed steel, onto at least part of which a hard and wear resistant coating is deposited, said coating comprising at least one layer deposited according to any of the above described embodiments of the inventive method. According to one embodiment said layer has a thickness of between 0.5 and 10 µm, preferably between 0.5 and 7 µm, most preferably between 1 and 5 µm, as measured in a region S of a cross section C, where
- said cross section C is made through, and approximately perpendicular to, the main cutting edge line at a position away from any extreme curvatures of said cutting edge line, such as corners or noses, and if possible, depending on the geometry of the tool, said cross section C is made at a position located between 2 and 3 mm away from any such extreme curvatures, and
- said region S is located away from the main cutting edge, if possible depending on the geometry of the tool region S is located between 0.5 and 0.6 mm away from the main cutting edge, in the direction giving the highest value of tₜₒₜ. The layer thus produced comprises at least one first sublayer deposited during a fraction Dₕᵢ of the total deposition time.

According to one embodiment of the invention, the coating comprises inner, outer, and/or intermediate deposits. Thereby a multilayer structure is formed. By deposit is herein meant a part of the coating structure which is not a layer or sublayer as defined in the present description.

According to one embodiment of the invention, the thickness of one layer is more than half of the total coating thickness, both thicknesses being evaluated as the maximum thickness of the layer and the coating, respectively, in region S.

According to one embodiment of the invention, each first sublayer has a thickness, tₛᵢ, greater than 0.05 µm, preferably greater than 0.1 µm, as evaluated in region S.

According to one embodiment of the invention, each first sublayer has a thickness distribution such that tₑᵢ/tₛᵢ < 1.5, preferably tₑᵢ/tₛᵢ < 1.2, as evaluated on the cross section C through the main cutting edge, where
- tₑᵢ is the maximum first sublayer thickness within the cutting edge region E of said cross section C, said region E being located on the main cutting edge radius, and
- tₛᵢ is the maximum first sublayer thickness within a region S of said cross section C, said region S being located, if possible depending on the geometry of the tool, between 0.5 and 0.6 mm away from region E, in the direction giving the highest value of tₛ.

In one embodiment of the invention the layer has a composition according to (Me,Q), where Me is one or more of Ti, V, Cr, Y, Zr, Nb, Mo, Hf, Ta, W, B, Al, and Si, preferably one or more of Ti, V, Cr, Y, Zr, Nb, Al, and Si, and where Q is one or more of B, C, N, O, and S, preferably one or more of C, N, and O.

The above definitions of Me and Q also apply for the other embodiments of the invention being concerned with the composition of the layer and described herein.

In one embodiment of the invention the average grain width, w, within a first sublayer is 2 nm < w < 200 nm, preferably 2 nm < w < 100 nm, as measured by scanning or transmission electron microscopy analysis in region S and averaged over at least 20 representative grains in the middle part of the first sublayer, i.e. within 20% to 80% of the first sublayer thickness.

In one embodiment of the invention the layer has a composition according to the chemical formula Me₁₋ₓQₓ, where 0.3 < x < 0.7, preferably 0.45 < x < 0.7, as evaluated by, for example, energy or wavelength dispersive x-ray spectroscopy in region S.

In one embodiment of the invention the layer has a composition according to the chemical formula Me₁₋ₓQₓ, where Me is at least two elements, Me1 and Me2, Me1 i-Me2, and the chemical composition within a first sublayer varies such that ΔC_{Me1} > 2 atomic percent, preferably ΔC_{Me1} > 5 atomic percent, where ΔC_{Me1} = C_{Me1,s} - C_{Me1,ei}, C_{Me1,si} is the maximum value of C_{Me1} = A_{Me1}/(A_{Me1} + A_{Me2}) in region S of said first sublayer, C_{Me1,ei} is the minimum value of C_{Me1} in region E of said first sublayer, A_{MeX}, X=1 or 2, is the average atomic content of MeX as measured by cross sectional analysis in the corresponding E or S regions by, e.g., energy or wavelength dispersive x-ray spectroscopy of a representative area in the middle part of the first sublayer, i.e. within 20% to 80% of the first sublayer thickness, and Me1 and Me2 are selected from the elements present in the first sublayer in order to give the highest possible value ΔC_{Me1}.

In one embodiment of the invention the layer contains mainly NaCl phase, preferably a single NaCl phase as identified by, e.g., x-ray or electron diffraction in the middle of the tool face where region S is located.

In one embodiment of the invention the layer contains mainly corundum structured crystalline grains as identified by, e.g., x-ray or electron diffraction in the middle of the tool face where region S is located.

In one embodiment of the invention all first and second sublayers have compositions, as evaluated by, e.g., energy or wavelength dispersive x-ray spectroscopy in region S, according to the chemical formula (Ti_{1-x1-y1}Alₓ₁-Me_{y1})(N₁₋ₐ₁Qₐ₁)_{z1}, where 0.1 < x1 < 0.7, preferably 0.3 < x1 < 0.7, 0 ≤ y1 < 0.3, preferably 0 ≤ y1 < 0.15, most preferably y1 = 0, 0.8 < z1 < 1.2, preferably 0.9 < z1 < 1.1, 0 ≤ a1 < 0.5, preferably 0 ≤ a1 < 0.3, most preferably a1 = 0.

In one embodiment of the invention all first and second sublayers have compositions, as evaluated by, e.g., energy or wavelength dispersive x-ray spectroscopy in region S, according to the chemical formula (Ti_{1-x2-y2}Siₓ₂Me_{y2})(N₁₋ₐ₂Q_{a2)z2}, where 0.01 < x2 < 0.25, 0 ≤ y2 < 0.3, preferably 0 ≤ y2 < 0.15, most preferably y2 = 0, 0.8 < z2 < 1.2, preferably 0.9 < z2 < 1.1, 0 ≤ a2 < 0.5, preferably 0 ≤ a2 < 0.3, most preferably a2 = 0.

In one embodiment of the invention all first and second sublayers have compositions, as evaluated by, e.g., energy or wavelength dispersive x-ray spectroscopy in region S, according to the chemical formula (Cr_{1-x4-y4}Alₓ₄Me_{y4})(O₁₋ₐ₄Qₐ₄)_{z4}, where 0 ≤ x4 < 0.75, preferably 0.3 < x4 < 0.75, 0 ≤ y4 < 0.3, preferably 0 ≤ y4 < 0.15, most preferably y4 = 0, 0.8 < z4 < 1.7, preferably 0.9 < z4 < 1.7, most preferably 1.3 < z4 < 1.7, 0 ≤ a4 < 0.5, preferably 0 ≤ a4 < 0.3, most preferably a4 = 0.

In one embodiment of the invention all first and second sublayers have compositions, as evaluated by, e.g., energy or wavelength dispersive x-ray spectroscopy in region S, according to the chemical formula (Cr_{1-x3-y3}Alₓ₃Me_{y3})(N₁₋ₐ₃Qₐ₃)_{z3}, where 0.3 < x3 < 0.75, 0 ≤ y3 < 0.3, preferably 0 ≤ y3 < 0.15, most preferably y3 = 0, 0.8 < z3 < 1.2, preferably 0.9 < z3 < 1.1, 0 ≤ a3 < 0.5, preferably 0 ≤ a3 < 0.3, most preferably a3 = 0.

In one embodiment of the invention all first and second sublayers have compositions, as evaluated by, e.g., energy or wavelength dispersive x-ray spectroscopy in region S, according to the chemical formula Ti(N₁₋ₐ₃Qₐ₃)_{z3}, where, 0.8 < z3 < 1.2, preferably 0.9 < z3 < 1.1, 0 ≤ a3 < 0.5, preferably 0 ≤ a3 < 0.3, most preferably a3 = 0.

In one embodiment of the invention, all first and second sublayers are nanolaminates consisting of alternating nanolayers of different chemical composition, where the average thicknesses of said nanolayers are between 1 and 100 nm, preferably between 1 and 50 nm, most preferably between 1 and 30 nm, as evaluated in region S over at least 10 adjacent nanolayers in the middle part of the first or second sublayer, i.e. within 20% to 80% of the sublayer thickness.

In one embodiment of the invention, all first and second sublayers are nanolaminates consisting of alternating nanolayers having nominal compositions according to the chemical formulas (Ti_{1-x1-y1}Alₓ₁Me_{y1})(N₁₋ₐ₁Qₐ₁)_{z1}, where 0.2 < x1 < 0.7, 0 ≤ y1 < 0.3, preferably 0 ≤ y1 < 0.15, most preferably y1 = 0, 0.8 < z1 < 1.2, preferably 0.9 < z1 < 1.1, 0 ≤ a1 < 0.5, preferably 0 ≤ a1 < 0.3, most preferably a1 = 0, and (Ti_{1-x2-y2}Siₓ₂Me_{y2})(N₁₋ₐ₂Qₐ₂)_{z2}, where 0.02 < x2 < 0.25, 0 ≤ y2 < 0.3, preferably 0 ≤ y2 < 0.15, most preferably y2 = 0,0.8 < z2 < 1.2, preferably 0.9 < z2 < 1.1, 0 ≤ a2 < 0.5, preferably 0 ≤ a2 < 0.3, most preferably a2 = 0, and where the average thicknesses of said nanolayers are between 1 and 100 nm, preferably between 1 and 50 nm, most preferably between 1 and 30 nm, as evaluated in region S over at least 10 adjacent nanolayers in the middle part of the first or second sublayer, i.e. within 20% to 80% of the sublayer thickness. By nominal compositions is meant that the compositions are evaluated, by, e.g., energy or wavelength dispersive x-ray spectroscopy in region S, on corresponding thick deposits produced with the same process parameters.

By applying the above described embodiments of the invention a cutting tool with increased wear resistance is achieved. The increased performance is related to the use of the first substrate bias potential during a significant fraction of the layer deposition time. Among the observed effects on coating properties gained by the invention the following are possible reasons for the increased performance:
- A beneficial thickness distribution is often achieved for the at least one first sublayer. Instead of the common dramatic increase in thickness over the cutting edge, the at least one first sublayer often display no significant such thickness increase. This give rise to an increased edge wear resistance in certain applications.
- It appears as if the amount and size of the droplets, commonly occurring when using arc evaporation, remaining on the layer surface are significantly reduced. Hence, by using a first sublayer as the top coat, a smoother tool surface is achieved which could result in significantly improved machining performance.
- For the case of layers with more than one metallic element a large gradient in chemical composition is produced within the at least one first sublayer. Since the properties of a layer vary with composition, this may also be a benefit in machining.

### BRIEF DESCRIPTION OF THE DRAWINGS

Figures 1a-f are schematical graphs showing the substrate bias potential, U_{b}, as a function of normalised deposition time according to embodiments of the invention.
Figures 2a-f are schematical drawings of example coatings deposited according to embodiments of the invention.
Figures 3a-h are schematic drawings showing examples of the position of a cross section C (dashed line) for some insert types.
Figure 4 is a schematic drawing of a cross section C for the case of a flat negative insert showing the positions of regions E and S.
Figures 5a-b show schematically the measurement positions of tₛ and tₑ for the same insert type as in Figure 4.
Figures 6a-b are maps of the Al/(Al+Ti) atomic ratio on the rake (a) and flank (b) faces fitted to energy dispersive x-ray spectroscopy (EDS) measurements on a (Ti,Al)N first sublayer deposited onto negative 12x12x4 mm square insert with 0° rake angle. The variables X, Y, and Z are defined in figure 6c.
Figure 7 is a fracture cross section scanning electron microscopy (SEM) image of one example of a (Ti,Al)N layer according to an embodiment of the present invention.
Figure 8 shows X-ray diffractograms recorded by (top) a θ-2θ scan and (bottom) a detector scan with ω=2° on a (Ti,Al)N layer consisting solely of one first sublayer according to an embodiment of the invention .

### DETAILED DESCRIPTION OF PREFERRED EMBODIMENTS

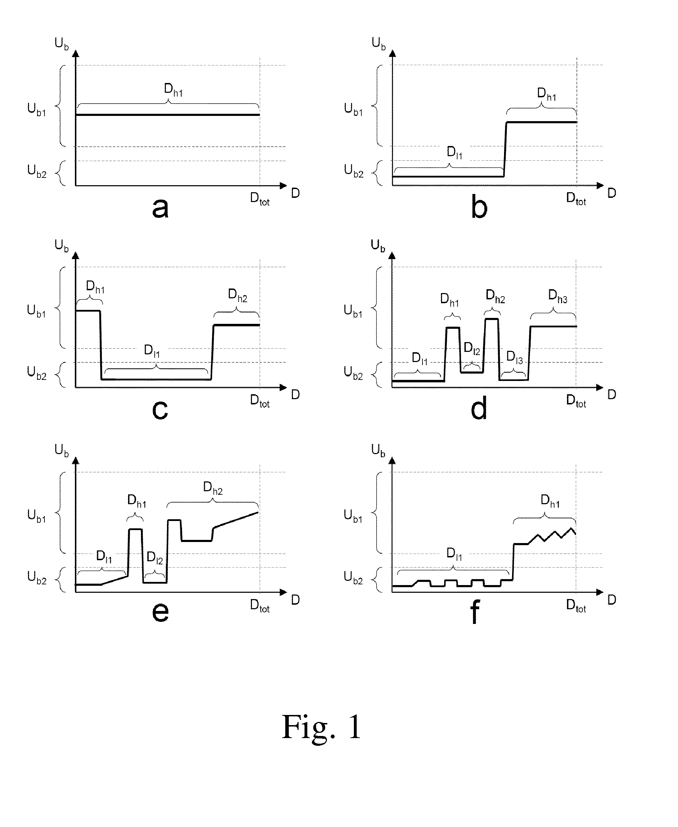

Figures 1a-f show schematic drawings of a substrate bias potential, U_{b}, as a function of layer deposition time, D, illustrating examples of some embodiments of the invention where a hard and wear resistant coating is deposited onto a tool body of a hard alloy. The coating comprises a layer 2 comprising at least one first sublayer 3. The method comprises depositing the layer by highly ionised physical vapour deposition using elemental, composite and/or alloyed source material comprising the elements Me, where Me is one or more of Ti, V, Cr, Y, Zr, Nb, Mo, Hf, Ta, W, B, Al, Si, and C, using a process gas comprising one or more of the elements C, N, O, and S. The method further comprises applying a first substrate bias potential, U_{b1}, where -900 V < U_{b1} < -250 V, during at least one fraction, Dₕᵢ, i=1,2,3,..., of the total layer deposition time, Dₜₒₜ, where Dₕᵢ > 0.05Dₜₒₜ.

In figure 1a a first substrate bias potential, U_{b1}, is applied for the entire layer deposition time (Dₕ₁=Dₜₒₜ). In figure 1b a second substrate bias potential, U_{b2}, is used for a predetermined fraction, D₁₁, of the total layer deposition time, Dₜₒₜ. Thereafter the substrate bias potential is ramped and a first substrate bias potential, U_{b1}, is used for the remaining fraction Dₕ₁ of Dₜₒₜ. In figure 1c a first substrate bias potential, U_{b1}, during a fraction Dₕ₁ is followed by a second substrate bias potential U_{b2} for a predetermined fraction, D₁₁, of Dₜₒₜ. Subsequently, the substrate bias potential is again ramped to a first substrate bias potential U_{b1} during a fraction Dₕ₂ of Dₜₒₜ. In figure 1d, the substrate bias potential, U_{b}, is varied between first and second substrate bias potentials, such that a first substrate bias potential is applied at different levels during three fractions, Dₕ₁, Dₕ₂, and Dₕ₃, of the total layer deposition time Dₜₒₜ, with intermediate fractions of second substrate bias potentials at three fractions, D₁₁, D₁₂, D₁₃, of the total layer deposition time Dₜₒₜ. In figures 1e and 1f the substrate bias potential, U_{b}, is varied in a more complex manner so that U_{b} is not constant during all fractions of first U_{b1} or second U_{b2} levels. It is evident that the drawings are only schematic examples, and it should be understood that several other embodiments of the substrate bias potential, U_{b}, as a function of layer deposition time, D, are covered by the invention as defined by the claims.

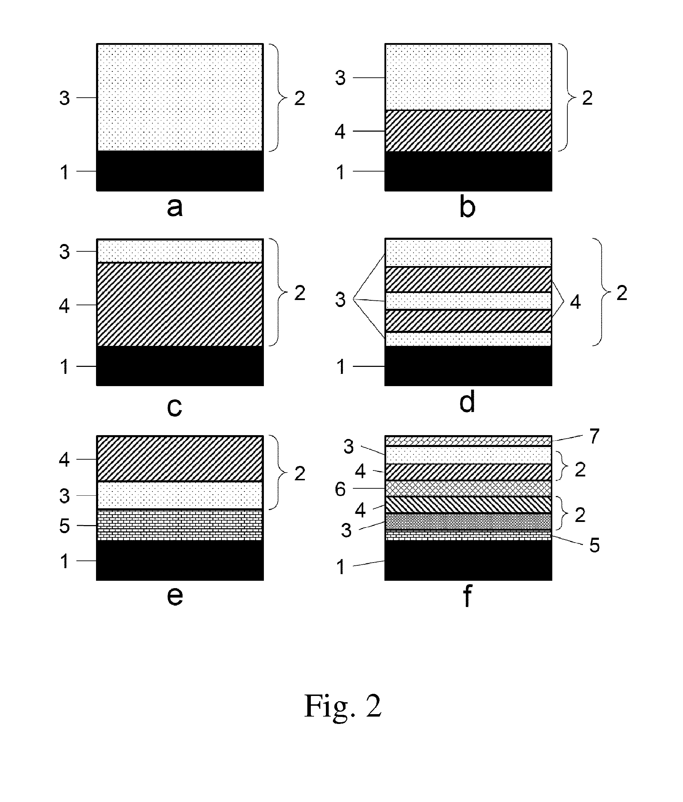

Figures 2a-f show some illustrations of coatings deposited according to embodiments of the invention, where figure 2a shows an example of the invention where a tool body 1 is coated with a coating consisting solely of a layer 2, the layer consisting solely of a first sublayer 3. The embodiment in figure 2b shows an embodiment of the invention where a body 1 is coated with a layer 2 consisting of an inner second sublayer 4 and an outer first sublayer 3. Figure 2c shows an alternative embodiment to figure 2b, where the inner second sublayer 4 is thicker and the outer first sublayer 3 thinner as compared to the respective sublayer in the embodiment of figure 2b. Figure 2d shows an embodiment where a body 1 is coated with a single layer 2 consisting of three first sublayers 3 and two second sublayers 4. Figure 2e shows an embodiment of the invention where the body 1 is coated with an inner deposit 5, onto which a layer 2 is deposited, consisting of a first sublayer 3 and an outer second sublayer 4. Figure 2f is an embodiment of the invention where the body is coated with an inner deposit 5, onto which two layers 2 are deposited separated by an intermediate deposit 6. Onto the outer of the two layers 2 an outer deposit 7 is applied. All first sublayers 3 are deposited during fractions Dₕᵢ of the total layer 2 deposition time, Dₜₒₜ, and all second sublayers 4 are deposited during fractions Dₗᵢ of the total layer 2 deposition time, Dₜₒₜ.

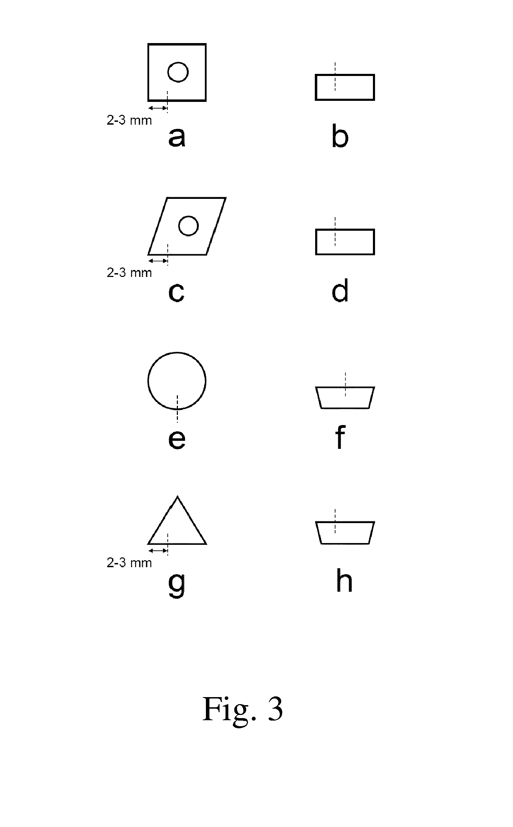

Figures 3a-h shows schematically the appropriate positions of a cross section C (dashed line) for some insert types. The cross section C is used in some of the embodiments of the invention for measurements of thickness and chemical compositional. According to these embodiments of the invention the cross section (C) is made through, and approximately perpendicular to, the main cutting edge line at a position away from any extreme curvatures of said cutting edge line, such as corners or noses. If possible, depending on the geometry of the tool, said cross section (C) is made at a position located between 2 and 3 mm away from any such extreme curvatures. Figure 3a-b is a square insert, figure 3c-d is a rhomboid, figure 3e-f is a round insert and figure 3g-h is a triangular insert. The dashed lines mark the appropriate positions, according to the above described embodiments of the invention, of cross sections (C) viewed from the top/rake face in figures 3a,c,e,g and from the side/flank in figure 3b, d, f, h. For the case of the round insert where no extreme edge line curvatures exist the cross section (C) is positioned at an arbitrary position perpendicular to the edge line.

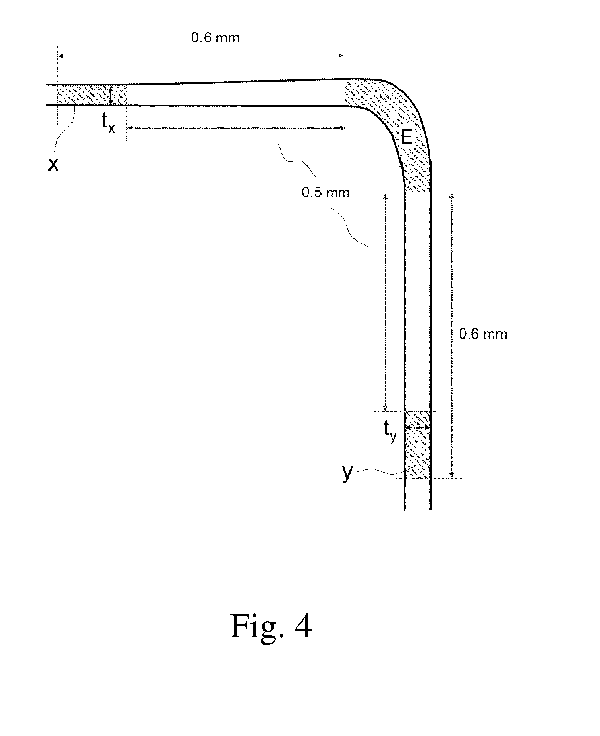

Figure 4 shows schematically a cross section (C) and the locations of regions E and S for the case of a flat negative insert. Regions E and S are used in several embodiments of the invention as locations for measuring thicknesses and chemical composition. Region E is the part of the layer which is located on the main cutting edge radius of the cross section (C). Region S is found by comparing the maximum thickness of the layer in two regions, x and y, located between 0.5 and 0.6 mm away from the edge region on the rake face (region x) and flank face (region y), respectively. In figure 4, t_{y} > tₓ, and thereby region y = S and tₛ = t_{y}, where the thicknesses tₓ, t_{y}, and tₛ represent the maximum thickness within the corresponding regions.

For measurements by x-ray diffraction as mentioned in some embodiments of the invention, it is not possible to measure in region S. Instead the measurement is made in the middle of the insert face where region S is located. As an example, for inserts with holes region S is typically located on the flank face of the insert and the x-ray diffractogram is then recorded in the middle of the flank face.

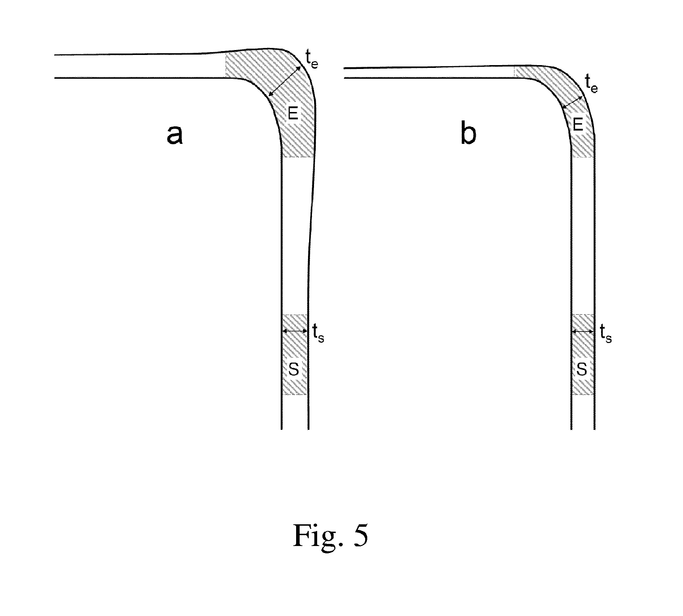

For evaluation of thicknesses and thickness distributions, some embodiments of the invention specify the measurement of the thicknesses tₑ and tₛ, which are defined as the maximum thickness within the respective region E and S. Figure 5 shows schematically two examples of the measurement positions for evaluation of tₑ and tₛ for the same insert type as shown in figure 4. Figure 5a and 5b are examples of different thickness distributions. It is evident that these drawings are only schematical examples and that layers according to the invention can be deposited also on other types of cutting tools, such as drills and end mills, and that if the geometry and/or size of the cutting tool prohibit the described thickness evaluations, the thickness distribution shall be investigated by closely related evaluations. It is further evident that the thickness distribution cannot be evaluated in regions suffering from delamination or where the thickness has been reduced by post-treatment, e.g., blasting or brushing.

Measurements of the chemical composition according to the embodiments of the invention are made in region S. It is evident that the compositional gradient between the E and S regions depends strongly on, for example, the geometry of the tool and the position of the cross section (C) such that, in general, the compositional difference between E and S regions becomes larger for sharper geometries. It is further evident that if the geometry and/or size of the cutting tool prohibit the described composition evaluations, the coating shall be evaluated by closely related evaluations.

### Example 1

A coating containing solely a (Ti,Al)N layer according to the invention was deposited by cathodic arc evaporation onto cemented carbide inserts with chemical composition 94 wt% WC + 6 wt% Co. Three insert geometries were used:
- Type I: SNMA120408, according to ISO-metric standard; 12 mm square negative insert with 0° rake angle
- Type II: CCMT120408, according to ISO-metric standard; positive insert with 7° clearance angle and 15° rake angle, and
- Type III: A 12 mm round negative insert with 0° rake angle.

In all three cases the edge radius was about 25 µm, the flank faces were facing the sources during deposition, and 3-fold fixture rotation was applied. Before deposition, the inserts were cleaned in ultrasonic baths of an alkali solution and alcohol. The deposition chamber was evacuated to a base pressure of less than 2.0x10⁻³ Pa, after which the inserts were sputter cleaned with Ar ions. The coating was deposited from 6 TiAl composite cathodes with composition Ti:Al = 34:66 in 99.995% pure N₂ atmosphere at a pressure of 4 Pa, a temperature of 450°C and the evaporator current was set to 70 A on each cathode. The substrate bias potential was initially kept at -40 V for 40 minutes resulting in an inner second sublayer, the potential was then ramped to -400 V at a ramping speed of about 100 V/s, and finally the substrate bias potential was kept at -400 V for the remaining 80 minutes of deposition time resulting in an outer first sublayer.

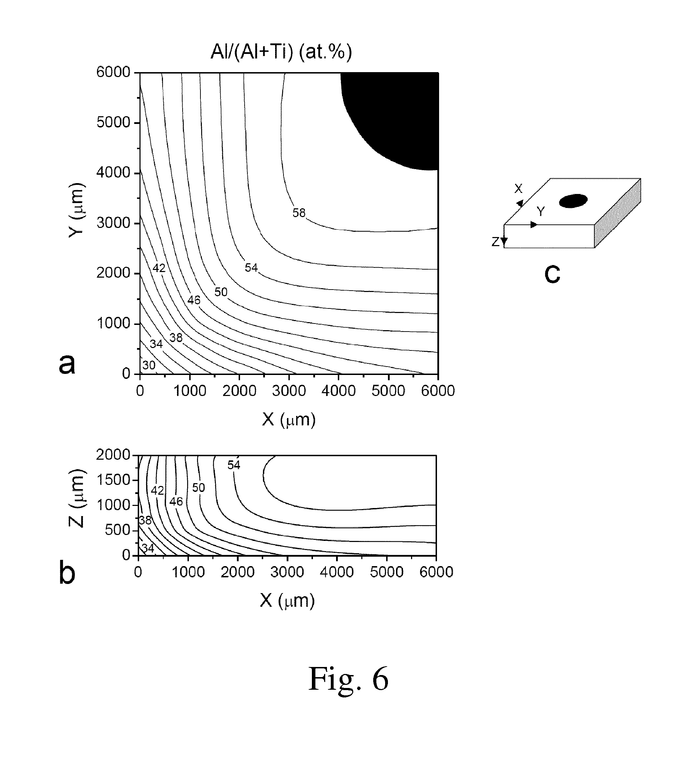

Figures 6a-b are maps of the Al/(Al+Ti) atomic ratio as evaluated on the rake, figure 6a, and flank faces, figure 6b, in the outer (Ti,Al)N first sublayer deposited on the insert type I. The variables X, Y, and Z are defined in figure 6c. The chemical composition was evaluated as an average from 10 point measurements by energy dispersive x-ray spectroscopy (EDS) analysis using a LEO Ultra 55 scanning electron microscope operated at 10 kV at 8,5 mm working distance, according to system set-up, and equipped with a Thermo Noran EDS detector. The data were evaluated using the Noran System Six (NSS version 2) software using built-in standards and ZAF correction. There is a clear compositional gradient with a higher Al content away from the cutting edge, lower at the edge, and lowest at the edge at the corner of the insert. The compositional difference between E and S regions was evaluated according to the embodiments of the invention and in order to maximise ΔC_{Me1}, Me1 is defined as Al and Me2 is defined as Ti in the present case. According to the embodiments of the invention the cross section (C) used in the evaluations should be positioned perpendicular to the main cutting edge at a distance of between 2 and 3 mm from the corner of the insert, see figure 3, and the regions E and S are found as described above, see figures 4 and 5. In the present case, if the cross section (C) is positioned 2 mm from one corner of the insert, then C_{Al,s1} is 54 at.% (maximum value in region S), C_{Al,e1} is 40 at.% (minimum value in region E), and ΔC_{Al} is therefore 14 at.% for the first sublayer. If the cross section (C) is instead positioned 3 mm from the corner of the insert, then C_{Al,s1} is 56 at.% (maximum value in region S), C_{Al,e1} is 44 at.% (minimum value in region E), and ΔC_{Al} is therefore 12 at.% for the first sublayer. If the same evaluations are made on the first sublayer on the type III insert (12 mm round), then C_{Al,s1} is 56 at.%, C_{Al,e1} is 46 at.%, and thus ΔC_{Al} 10 at.% in this case. Since there are no corners on the type III insert, the cross section (C) is positioned perpendicular to the edge and through the centre of the insert. This demonstrates that the value of ΔC_{Al} for a first sublayer is influenced by the tool geometry and the position of the cross section (C).

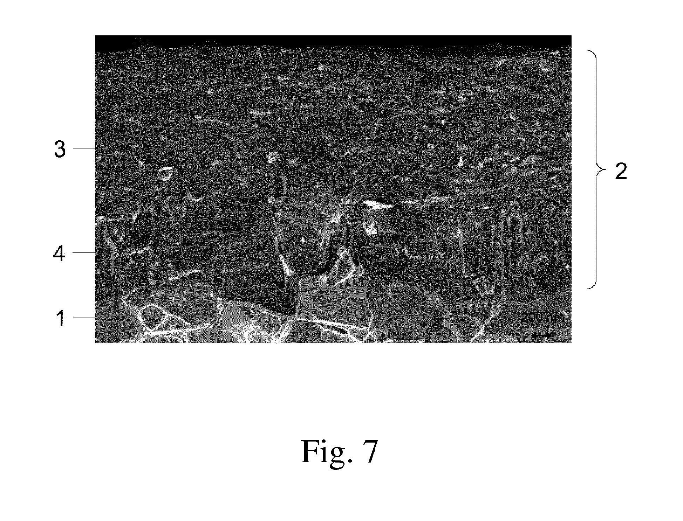

Figure 7 shows a fracture cross sectional scanning electron microscopy (SEM) image of the layer 2 showing the body 1, the inner (Ti,Al)N second sublayer 4, and the outer (Ti,Al)N first sublayer 3. The SEM image is taken in region S of the insert of type I.

The cross section (C) was positioned 3 mm from the corner of the insert and region S is located between 0.5 and 0.6 mm from the cutting edge in the direction of the flank face. In this region the average grain size of the first sublayer was estimated to be 50 nm and the thickness was 1.8 µm for the first sublayer and 0.9 µm for the inner second sublayer. At the thickest point in region E the corresponding thicknesses were 1.5 µm and 1.5 µm, respectively, and on the rake face 0.5 mm from the edge the measured thicknesses were 1.4 and 0.8 µm, respectively. For insert type I the ratio tₑ₁/tₛ₁ as used in the embodiments of the invention is thus 0.85 for the first sublayer and the corresponding ratio for the second sublayer is 1.7.

A corresponding thickness measurement was made for insert type II (having a sharper geometry and a relatively high rake angle). The measured thicknesses for the first sublayer and the inner second sublayer, respectively, were then 1.4 µm and 0.7 µm in region S, 1.5 µm and 1.5 µm in region E, and 0.5 µm and 0.6 µm on the rake face 0.5 mm from the edge. For insert type II the ratio tₑ₁/tₛ₁ is thus 1.1 for the first sublayer and the corresponding ratio for the inner second sublayer is 2.1. It is clear that the ratio tₑᵢ/tₛᵢ is influenced by tool geometry and it seems that the thickness on the rake face for the first sublayer is more sensitive to tool geometry than the corresponding thickness for the inner second sublayer.

### Example 2

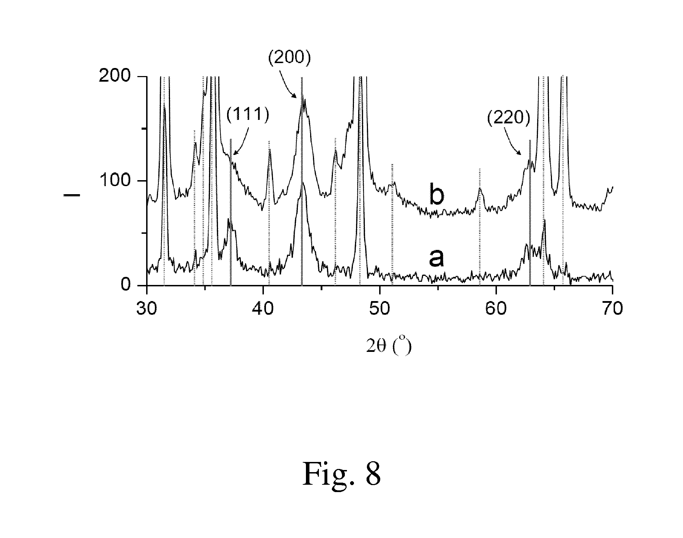

A single (Ti,Al)N first sublayer was deposited onto an insert type I using the same cathodes and deposition conditions as for the first sublayer in example I. The thickness was 2 µm as measured in region S, which was located on the flank face of the insert. Figure 8 shows x-ray diffractograms from (a) a detector scan with ω=2° and (b) a θ-2θ scan, both scans being recorded in the middle of the flank face of the insert. Apart from substrate peaks (dotted lines) the diffractograms display only NaCl peaks (solid lines) originating from the (Ti,Al)N first sublayer.

### Example 3

Coatings according to several embodiments of the invention as specified in table 1 were deposited onto cemented carbide and cubic boron nitride based inserts by means of cathodic arc evaporation. All coatings consist of one layer consisting of one or two sublayers and no additional deposits were applied. For each coating the sublayer A in table 1 was deposited onto the body (insert) and the sublayer B (samples I2-I7) was deposited onto sublayer A. Depending on the substrate bias potential used during deposition of the sublayers A and B they correspond to first or second sublayers according to the embodiments of the invention as indicated in table 1.

The comparative coatings specified in table 2 were deposited onto cemented carbide and cubic boron nitride based inserts by means of cathodic arc evaporation. Deposition setup, nitrogen pressure, and temperature were the same as in example 1.

The thicknesses specified in tables 1 and 2 were measured in region S located on the flank faces, which were facing the cathodes during deposition. All samples contained mainly NaCl crystal structure as determined from x-ray diffraction measurements in the middle of the flank faces of the inserts (the insert face where region S is located).

**Table 1. Deposition conditions and resulting layer thicknesses (as evaluated in region S) for coatings deposited according to several of the embodiments of the invention. Nitrogen pressure and temperature were the same as in example 1.**

| Sample | Cathode | Sublayer A | | Sublayer B | | Sublayer type | |
|---|---|---|---|---|---|---|---|
| | | U_{b} (V) | tₛ (µm) | U_{b} (V) | tₛ (µm) | First | Second |
| I1 | Ti₃₄Al₆₆ | -400 | 2 | - | - | A | - |
| I2 | Ti₃₄Al₆₆ | -400 | 1 | -50 | 1 | A | B |
| I3 | Ti₃₄Al₆₆ | -400 | 0.5 | -50 | 1.5 | A | B |
| I4 | Ti₃₄Al₆₆ | -50 | 0.5 | -400 | 1.5 | B | A |
| I5 | Ti₃₄Al₆₆ | -50 | 1.5 | -400 | 0.5 | B | A |
| I6 | Ti | -50 | 1.5 | -400 | 0.5 | B | A |
| I7 | Ti₈₀Si₂₀ | -400 | 0.3 | -50 | 1.7 | A | B |

**Table 2. Deposition conditions and resulting thicknesses for comparative coatings according to prior art. Nitrogen pressure and temperature were the same as in example 1.**

| Sample | Cathode | U_{b} (V) | tₛ (µm) |
|---|---|---|---|
| C1 | Ti₃₄Al₆₆ | -50 | 2 |
| C2 | Ti₃₄Al₆₆ | -100 | 2 |
| C3 | Ti₃₄Al₆₆ | -200 | 2 |
| C4 | Ti₈₀Si₂₀ | -50 | 2 |

### Example 4

A coating was deposited according to an embodiment of the invention onto an insert of type I from example 1. The process conditions were similar as for the coating in example 1 but using stronger magnetic fields at the cathode surface and a significantly higher plasma density at the substrate position. During the deposition of the first layer the higher plasma density caused a 50% increase in substrate bias current. The surface morphology of the resulting coating was compared to the coating from example 1 and to coating C1 from example 3. This comparison showed that the amount and size of the droplets remaining on the coating surfaces were highest for coating C1, lower for the coating from example 1, and lowest for the coating of the present example. It is believed that the smoother surfaces of coatings deposited according to the embodiments of the invention are due to a sputtering effect of the depositing ions and that the smoother surfaces are beneficial in machining applications.

### Example 5

Coatings C1-C3 and I1-I5 from example 3 were tested under the following conditions:

| | |
|---|---|
| Geometry: | XOEX120408R-M07 |
| Application: | Dry square shoulder milling |
| Work piece material: | AISI 316L |
| Cutting speed: | 180 m/min |
| Feed: | 0.12 mm/tooth |
| Depth of cut: | 3 mm |
| Width of cut: | 26 mm (81%) |
| Tool life criteria: | Flank wear (vb) > 0.2 mm |

**Table 3. Relative life time in the cutting test.**

| Sample no. | Life time (%) |
|---|---|
| C1 | 100 |
| C2 | 70 |
| C3 | 20 |
| I1 | 140 |
| I2 | 150 |
| I3 | 110 |
| I4 | 200 |
| I5 | 130 |

It is clear that the coatings deposited according to the method of the invention perform significantly better than the comparative coatings.

### Example 6

Coatings C1, I3, and I4 from example 3 were tested under the following conditions:

| | |
|---|---|
| Geometry: | 16ER1.5ISO |
| Application: | Threading |
| Work piece material: | AISI 316L |
| Cutting speed: | 275 m/min |
| Feed: | 0.15 mm/rev |
| Depth of cut: | 0.75 mm |
| Tool life criteria: | Edge wear |

**Table 4. Edge wear performance.**

| Sample no. | Edge wear resistance |
|---|---|
| C1 | Poor |
| I3 | Medium |
| I4 | Good |

The coatings deposited according to the method of the invention displayed higher edge wear performance compared to the comparative coating. The edge wear was evaluated by visual inspection of the edge line.

### Example 7

Coatings C1, I1, I4, and I5, from example 3, were tested under the following conditions:

| | |
|---|---|
| Geometry: | 10 mm square shoulder end mill |
| Application: | Square shoulder milling |
| Work piece material: | AISI 316L |
| Cutting speed: | 100 m/min |
| Feed: | 0.075 mm/tooth |
| Depth of cut: | 8 mm |
| Width of cut: | 4 mm (40%) |
| Tool life criteria: | Edge wear |

**Table 4. Edge wear performance.**

| Sample no. | Edge wear resistance |
|---|---|
| C1 | Poor/Medium |
| I1 | Medium/Good |
| I5 | Good |
| I4 | Medium/Good |

The coatings deposited according to the method of the invention displayed significantly higher edge wear performance compared to the comparative coating. The edge wear was evaluated by visual inspection of the edge line.

It should be understood that alternative embodiments within the claimed scope of protection as defined in the annexed patent claims will be obvious to a person skilled in the art, and that that such alternative embodiments are to be regarded as within the claimed scope of protection. For example, the claimed method is also applicable to other material systems than the one specified in the above examples. The following are examples of such material systems: Al-Cr-N, Al-Cr-O, Ti-Al-Si-N, and Ti-Al-Cr-N.

## Claims

1. A method for depositing a hard and wear resistant coating onto a tool body (1) of a hard alloy of, for example, cemented carbide, cermet, ceramics, cubic boron nitride based material or high speed steel, wherein said coating comprises a layer (2) comprising at least one first sublayer (3), and said method comprises
- depositing the layer (2) by highly ionised physical vapour deposition using elemental, composite and/or alloyed source material comprising the elements Me, where Me is one or more of Ti, V, Cr, Y, Zr, Nb, Mo, Hf, Ta, W, B, Al, Si, and C, preferably one or more of Ti, V, Cr, Y, Zr, Nb, Al, and Si, most preferably one or more of Ti, Cr, Al, and Si,
- using a process gas comprising one or more of the elements C, N, O, and S, preferably one or more of C, N, and O, most preferably one or more of N₂ and O₂,
- and applying a first substrate bias potential, U_{b1}, where -900 V < U_{b1} < -250 V, during at least one fraction, Dₕᵢ, i=1,2,3,..., of the total layer deposition time, Dₜₒₜ, where Dₕᵢ > 0.05Dₜₒₜ, preferably Dₕᵢ > 0.1Dₜₒₜ, whereby one first sublayer (3) is formed during the at least one fraction Dₕᵢ.

2. A method according to claim 1, wherein the method comprises applying a second substrate bias potential, U_{b2}, where -150 V < U_{b2} < 0 V, during at least one fraction, Dₗᵢ, i=1,2,3,..., of the total deposition time, Dₜₒₜ, said fractions Dₗᵢ being located before, after, and/or between fractions Dₕᵢ, and whereby one second sublayer (4) is formed during the at least one fraction Dₗᵢ.

3. A method according to any of the preceding claims, wherein the substrate bias potential ramping time between a fraction Dₕᵢ and a fraction Dₗᵢ, or between a fraction Dₗᵢ and a fraction Dₕᵢ, is less than 0.02Dₜₒₜ, preferably less than 0.01Dₜₒₜ.

4. A method according to any of the preceding claims, wherein the first substrate bias potential, U_{b1}, is between -300 and -700 V.

5. A method according to any of the preceding claims, wherein the method comprises
- using cathodic arc evaporation with one or more cathodes,
- applying a process pressure, p, where 0.3 Pa < p < 8 Pa, preferably 0.5 < p < 6 Pa,
- applying a process temperature, T, where 200°C < T < 800°C, preferably 300°C < T < 600°C, and
- applying an evaporation current between 50 and 300 A for each cathode, preferably between 50 and 200 A for each cathode.

6. A method according to any of claims 1-4, wherein the method comprises
- using highly ionised magnetron sputtering,
- applying a process pressure, p, where 0.1 Pa < p < 5 Pa, preferably 0.1 < p < 2.5 Pa,
- applying a process temperature, T, where 200°C < T < 800°C, preferably 300°C < T < 600°C, and
- applying an average power density to the sputter target between 0.5 and 15 W/cm², preferably between 1 and 5 W/cm².

7. A method according to any of the preceding claims, wherein the layer deposition comprises at least two fractions Dₕᵢ.

8. A method according to any of claims 1-6, wherein the layer deposition comprises at least one sequence Dₗᵢ + Dₕᵢ, i=1,2,3,..., each fraction Dₕᵢ being located at the end of each sequence Dₗᵢ + Dₕᵢ.

9. A method according to any of claims 1-6, wherein the layer deposition comprises a single fraction Dₕ₁, and a single fraction Dₗ₁, said fraction Dₕ₁ being located at the end of the layer deposition time.

10. A method according to any of the preceding claims, wherein the method comprises depositing the layer using a source material having a composition according to the chemical formula Ti_{1-X1-Y1}Al_{X1}Me_{Y1}, where 0.2 < X1 < 0.7, preferably 0.4 < X1 < 0.7, 0 ≤ Y1 < 0.3, preferably 0 ≤ Y1 < 0.15, most preferably Y1 = 0, and a process gas containing one or more of the elements N, C, and O, preferably said process gas is N₂.

11. A method according to any of claims 1-9, wherein the method comprises depositing the layer using a source material having a composition according to the chemical formula Ti_{1-X2-Y2}Si_{X2}Me_{Y2} where 0.02 < X2 < 0.30, 0 ≤ Y2 < 0.3, preferably 0 ≤ Y2 < 0.15, most preferably Y2 = 0, and a process gas containing one or more of the elements N, C, and O, preferably said process gas is N₂.

12. A method according to any of claims 1-9, wherein the method comprises depositing the layer using a source material having a composition according to the chemical formula Cr_{1-X3-Y3}Al_{X3}Me_{Y3}, where 0 ≤ X3 < 0.75, preferably 0.3 < X3 < 0.75, 0 ≤ Y3 < 0.3, preferably 0 ≤ Y3 < 0.15, most preferably Y3 = 0, and a process gas containing one or more of the elements N, C, and O, preferably said process gas is O₂

13. A method according to any of claims 1-9, wherein the method comprises depositing the layer using a source material consisting of Ti and a process gas containing one or more of the elements N, C, and O, preferably said process gas is N₂.

14. A method according to any of claims 1-12, wherein the method comprises depositing the layer using at least two different, simultaneously active, source materials having different chemical compositions.

15. A method according to any of claims 1-9, wherein the method comprises depositing the layer using two different, simultaneously active, source materials having compositions according to the chemical formulas Ti_{1-X1-Y1}Al_{X1}Me_{Y1}, where 0.2 < X1 < 0.7, preferably 0.4 < X1 < 0.7, 0 ≤ Y1 < 0.3, preferably 0 ≤ Y1 < 0.15, most preferably Y1 = 0, and Ti_{1-X2-Y2}Si_{X2}Me_{Y2} where 0.02 < X2 < 0.30, 0 ≤ Y2 < 0.3, preferably 0 ≤ Y2 < 0.15, most preferably Y2 = 0, and using a process gas containing one or more of the elements N, C, and O, preferably said process gas is N₂.

16. A cutting tool for metal machining by chip removal, wherein said tool comprises a tool body (1) of a hard alloy of, for example, cemented carbide, cermet, ceramics, cubic boron nitride based material or high speed steel, onto at least part of which a hard and wear resistant coating is deposited, wherein said coating comprises at least one layer (2) deposited according to the method in any of claims 1-15, and wherein the at least one layer (2) comprises at least one first sublayer (3).

17. A cutting tool according to claim 16, wherein said layer (2) has a thickness of between 0.5 and 10 µm, preferably between 0.5 and 7 µm, most preferably between 1 and 5 µm, as measured in a region S of a cross section C, where
- said cross section C is made through, and approximately perpendicular to, the main cutting edge line at a position away from any extreme curvatures of said cutting edge line, such as corners or noses, and if possible, depending on the geometry of the tool, said cross section C is made at a position located between 2 and 3 mm away from any such extreme curvatures, and
- said region S is located between 0.5 and 0.6 mm away from the main cutting edge, in the direction giving the highest value of the layer thickness, and where the layer (2) thus produced comprises the at least one first sublayer (3) deposited during a fraction Dₕᵢ.

18. A cutting tool according to any of claims 16 or 17, wherein the coating comprises inner, outer, and/or intermediate deposits (5, 6, 7).

19. A cutting tool according to any of claims 16-18 , wherein each first sublayer (3) has a thickness, tₛᵢ, greater than 0.05 µm, preferably greater than 0.1 µm, as evaluated in region S.

20. A cutting tool according to any of claims 16-19, wherein the layer (2) has a composition according to the chemical formula Me₁₋ₓQₓ, where Me is at least two elements, Me1 and Me2, Me1 ≠ Me2, and the chemical composition within a first sublayer (3) varies such that ΔC_{Me1} > 2 atomic percent, preferably ΔC_{Me1} > 5 atomic percent,
Where ΔC_{Me1} =C_{Me1,si} - C_{Me1,ei}, C_{Me1,si} is the maximum value of C_{Me1} = A_{Me1}/(A_{Me1} + A_{Me2}) in region S of said first sublayer, C_{Me1,ei} is the minimum value of C_{Me1} in region E of said first sublayer, A_{Mex}, X=1 or 2, is the average atomic content of MeX as measured by cross sectional analysis in the corresponding E or S regions by, e.g., energy or wavelength dispersive x-ray spectroscopy of a representative area in the middle part of the first sublayer, i.e. within 20% to 80% of the first sublayer (3) thickness, and where Me1 and Me2 are selected from the elements Me present in the first sublayer (3) in order to give the highest possible value ΔC_{Me1}.

21. A cutting tool according to any of the claims 16-20, wherein all first and second sublayers have compositions, as evaluated by, e.g., energy or wavelength dispersive x-ray spectroscopy in region S, according to the chemical formula (Ti_{1-x1-y1}Alₓ₁Me_{y1})(N₁₋ₐ₁Qₐ₁)_{z1}, where 0.1 < x1 < 0.7, preferably 0.3 < x1 < 0.7, 0 ≤ y1 < 0.3, preferably 0 ≤ y1 < 0.15, most preferably y1 = 0, 0.8 < z1 < 1.2, preferably 0.9 < z1 < 1.1, 0 ≤ a1 < 0.5, preferably 0 ≤ a1 < 0.3, most preferably a1 = 0.
